# EUROPÄISCHE PATENTSCHRIFT

(11) **EP 0 512 133 B1**
(45) Veröffentlichungstag und Bekanntmachung des Hinweises auf die Patenterteilung: **02.01.1997**
(21) Anmeldenummer: 91107238.7
(22) Anmeldetag: 03.05.1991
(51) Int. Cl.: H03J 7/32, H04N 5/60, H04N 7/06

(54) **Verfahren zur automatischen Suchlaufabstimmung von Satelliten-Fernsehtonträgern**
Method for automatic sweep tuning of audio carriers for satellite television
Procédé d'accord automatique par balayage de porteuses son pour télévision par satellites

(43) Veröffentlichungstag der Anmeldung: 11.11.1992
(73) Patentinhaber: Deutsche ITT Industries GmbH, 79108 Freiburg (DE)
(72) Erfinder: Hilpert, Thomas, Dipl.-Ing., W-7803 Gundelfingen (DE); Müller, Stefan, Dipl.-Ing., W-7800 Freiburg (DE)

(56) Entgegenhaltungen:
- EP-A- 0 355 172
- EP-A- 0 356 555
- US-A- 4 698 670
- PATENT ABSTRACTS OF JAPAN vol. 12, no. 256 (E-635)(3103) 19. Juli 1988 & JP-A-63 043 315 ( SONY CORP ) 24. Februar 1988
- ELEKTRONIK. Bd. 6, 16. März 1990, MUNCHEN DE Seiten 50 - 56; T. HILPERT U. A.: 'Digitaler Multistandard-Audio-Chipsatz'
- 'AMU 2481 VS AUDIO PROCESSOR FOR VIDEO RECORDERSAND SATELLITE RECEIVERS' Herausgabe 18. Februar 1991, Nr. 6251-326-1E, ITT Semiconductors, Freiburg, DE

## Beschreibung

1. Die Erfindung betrifft ein Verfahren zur Frequenzabstimmung der frequenzmodulierten Tonträger von Mehrton-Übertragungsstandards bei einem für TV-Satellitenempfang geeigneten Fernsehempfänger unter Verwendung einer digitalen Tonkanalverarbeitungseinrichtung mit einem Quadraturmischer, einem Kanalfilter, einem Demodulator, einer Tonstufe und einer zentralen Steuereinrichtung, die mittels eines in der Frequenz programmierbaren digitalen Generators den Quadraturmischer durchstimmt, vgl. den Oberbegriff des Anspruchs 1.

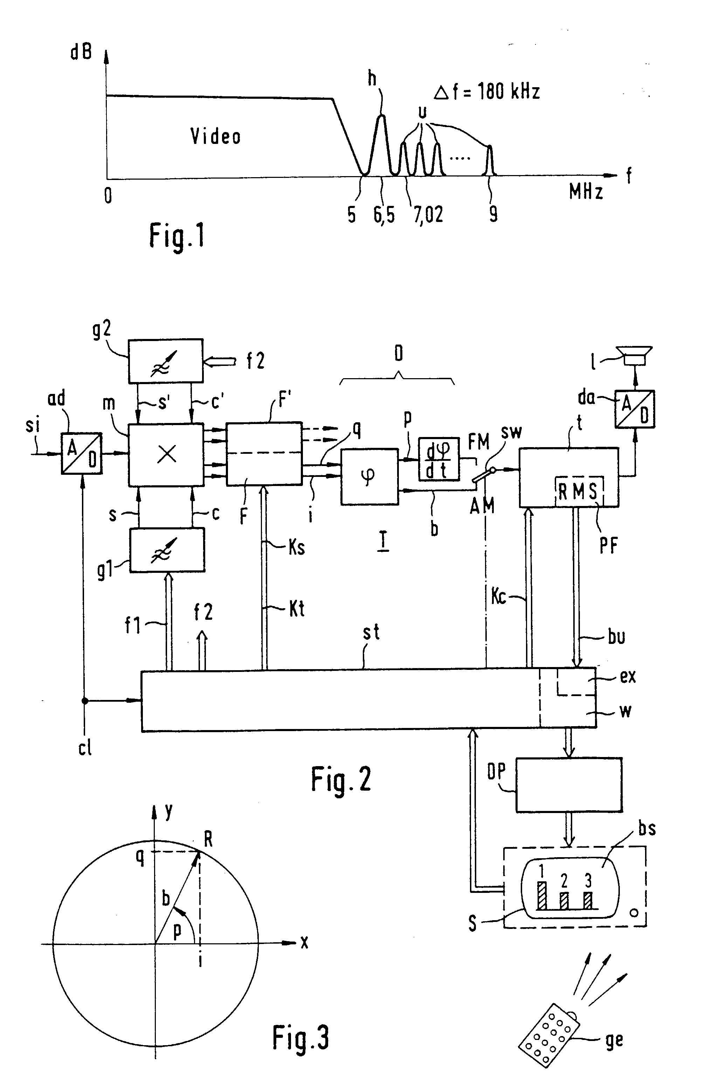

Ein derartiges Verfahren mit zugehöriger Schaltungsanordnung ist in dem Aufsatz "Digitaler Multistandard-Audio-Chipsatz" in "Elektronik", Nr.6, 16. März 1990, Seiten 50 bis 56 beschrieben, vgl. insbesondere Bild 5 auf Seite 57, das die zugehörige Blockschaltung zeigt. Im Datenblatt der Fa. Intermetall, Ausgabe 18. Februar 1991, ist unter dem Titel "AMU 2481 VS-Audioprocessor for Video Recorders and Satellite Receivers" hierzu der in dem obigen System enthaltene Audioprozessor beschrieben, vgl. insbesondere Seite 4 mit der Fig. 1-1, die das zugehörige Blockschaltbild zeigt. Die Darstellung mit zugehöriger Beschreibung zeigt unter anderem zwei mittels Koeffizienten steuerbare adaptive Deemphasis-Schaltungsblöcke, sowie zwei Effektivwertbildner, die am rechten und linken Tonkanal angeschlossen sind und die der Steuerung der adaptiven Deemphasis dienen. Die Ausgangssignale dieser Effektivwertbildner sind über einen Datenbus mit einem Mikroprozessor verbunden, der in der Figur selbst nicht dargestellt ist, jedoch für den Audioprozessor die verschiedenen Koeffizienten vorgibt.

Da es bisher auf internationaler Ebene nicht gelungen ist, für die direkt empfangbaren Satellitenkanäle einen einheitlichen Audiostandard, insbesondere für den Mehrtonbetrieb, vorzusehen, ist es erforderlich, einen Fernsehempfänger, der für einen möglichst universellen TV-Satelliten-Empfang geeignet sein soll, mit einem möglichst universellen Multistandard-Audio-Empfangsteil auszurüsten. Eine wesentliche Schwierigkeit stellt hierbei die unterschiedliche Position der einzelnen FM-Tonträger innerhalb des Ton-ZF-Frequenzbereiches bei den einzelnen Satellitenkanälen dar. Die gezielte Einstellung eines speziellen Mehrtonkanals erfordert daher in der Regel vom Bedienenden die genaue Kenntnis über die jeweilige Position der FM-Tonträger und vom Gerät die Fähigkeit, die gewünschte Überlagerungsfrequenz genau einzustellen.

Es ist daher Aufgabe der Erfindung, ein Verfahren anzugeben, das bei TV-Satelliten-Fernsehempfängern für vorhandene und zukünftige Mehrtonverfahren eine bedienungsfreundliche Einstellung eines beliebigen Tonkanals - bei Stereobetrieb sind zwei Tonkanäle einzustellen - ermöglicht, wobei aus Kostengründen möglichst vorhandene Schaltungsteile der Tonverarbeitungseinrichtung verwendet werden sollen.

Die Lösung dieser Aufgabe erfolgt durch die in den Ansprüchen gekennzeichnete Erfindung, die im wesentlichen darin besteht, daß durch die Verwendung eines Suchlaufverfahrens für die unbekannten Tonträger, die Kenntnis über ihre Lage innerhalb des Ton-ZF-Bereichs entfallen kann. Für das Suchlaufverfahren wird der FM-Demodulator auf AM-Demodulation umgeschaltet und das FM-Kanalfilter in seiner Durchlaßbandbreite so weit eingeengt, daß die FM-Mittenfrequenz über eine Amplitudenauswertung erfaßt werden kann.

Als Kriterium dient hierbei die Bestimmung der mittleren Amplitudendichte, z.B. über eine gemittelte Effektivwertmessung, in jedem Suchlaufschritt. Aus dem Vergleich der mittleren Amplitudendichte benachbarter Suchlaufintervalle wird das relative Maximum bestimmt und das zugehörige Suchlaufintervall bildet die gesuchte FM-Mittenfrequenz. Zweckmäßig erweist sich hierbei eine Schrittweite von beispielsweise 10 kHz. Es ist hierbei anzumerken, daß bei der FM-Modulation die Trägeramplitude konstant bleibt und daß lediglich über eine frequenzbezogene Amplitudendichtemessung eine FM-Mittenfrequenzbestimmung möglich ist.

Besonders vorteilhaft für die Lösung der Aufgabe erweist sich, daß die vorhandene Tonkanalverarbeitungsschaltung eine Digitalschaltung ist, die Daten verarbeitet, weil dann die Filter und Tonstufen durch Änderung der zugeführten Koeffizienten in ihrem Frequenzverhalten gesteuert werden können.

Die Erfindung und weiter Vorteile werden nun anhand der Figuren der Zeichnung näher erläutert:
Fig. 1 zeigt als Beispiel das Frequenzschema eines TV-Satellitenkanals in Basisbandlage,
Fig. 2 zeigt als Blockschaltbild ein Schaltungsbeispiel zur Durchführung des Suchlaufverfahrens nach der Erfindung,
Fig. 3 zeigt das Zeigerdiagramm eines Tonträgers bei Quadraturdemodulation,
Fig. 4 zeigt ein Flußdiagramm einer einfachen Suchlaufsteuerung,
Fig. 5 zeigt ein Flußdiagramm einer komfortablen Suchlaufsteuerung und
Fig. 6 zeigt ein Beispiel für eine Menue-Darstellung der auszuwählenden Tonträger.

Fig. 1 zeigt schematisch das Beispiel eines vollständigen Satelliten-Fernsehkanals in Basisbandlage mit dem Videoteil bis ca. 5 MHz und dem darüber liegenden Ton-ZF-Bereich bis etwa 9 MHz. Unmittelbar an den Video-Frequenzbereich schließt sich der Hauptträger h bei 6,5 MHz an, der in der Regel in seiner Amplitude größer als die anderen Tonträger ist und in der Regel ein Monosignal enthält. Die darüberliegenden Tonträger werden als Unterträger u bezeichnet und enthalten entweder den Stereosignalteil oder unterschiedliche Sprachen. Die einzelnen Unterträger u liegen dabei im Abstand von 180 kHz auseinander.

Fig. 2 zeigt das Blockschaltbild einer Schaltungsanordnung zur Durchführung des Suchlaufverfahrens. In dem Blockschaltbild sind nur Schaltungsteile enthalten, die der bereits vorhandenen Tonsignalverarbeitung entstammen oder die bisher anderen Funktionen dienten. Das Eingangssignal si ist ein analoges Signal, das zumindest den gesamten Audiosignalbereich umfaßt, der in dem angenommenen Beispiel von Fig. 1 etwa von 5,5 MHz bis 9,2 MHz reicht. Das analoge Signal si wird mit Hilfe eines Analog-Digitalumsetzers ad und eines Systemtaktes cl digitalisiert und dem Eingang eines Quadraturmischers m zugeführt. Dieser ist als Doppelmischer ausgebildet, weil für die Stereowiedergabe in der Regel zwei FM-Tonträger demoduliert werden müssen. Der Doppelmischer m wird daher aus zwei digitalen Generatoren g1, g2 gespeist, die jeweils ein Überlagerungssignalpaar s, c; s', c Steuereinrichtung st über ein erstes und zweites Datenwort f1, f2 eingestellt wird. Als digitaler Generator dient beispielsweise ein periodisch überlaufender Akkumulator, der mit jedem Systemtakt cl zu seinem bisherigen Inhalt das jeweilige Datenwort f1, f2 hinzuaddiert und mit einer Anzahl höchstwertiger Stellen des Akkumulatorinhaltes, die dem momentanen Phasenwert zwischen 0 Grad und 360 Grad entsprechen, eine Festwert-Speichertabelle ansteuert, daraus die zugehörigen Sinuswerte s und Cosinuswerte c des Überlagerungssignalpaars ausliest und den Dateneingängen des Quadraturmischers zuführt. Die mittlere Periode des überlaufenden Akkumulators entspricht genau der gewünschten Überlagerungsfrequenz.

Der Doppel-Quadraturmischer m liefert als Ausgangssignale zwei Quadratursignalpaare an ein Doppelkanalfilter F', wobei für die Weiterbetrachtung des Suchlaufverfahrens lediglich das Kanalfilter F von Interesse ist, das mit dem ersten digitalen Generator g1 gekoppelt ist. Die Bandbreite dieses Kanalfilters F, die während des normalen FM-Betriebes zwischen 130 kHz und 380 kHz liegt, wird während des Suchlaufs über entsprechende Suchlaufkoeffizienten Ks auf eine Bandbreite zwischen 20 kHz und 50 kHz von der zentralen Steuereinrichtung st umgeschaltet. Die Umschalt-Fähigkeit dieses Kanalfilters F auf unterschiedliche Bandbreiten ist bereits durch die vorhandene Tonkanalverarbeitungseinrichtung T vorgegeben, wobei über unterschiedliche Betriebskoeffizienten Kt die Bandbreite an unterschiediiche Betriebsbedingungen angepaßt wird, je nach dem, ob ein Haupt- oder ein Unterträger h, u ausgefiltert werden muß. Das Ausgangssignal dieses Kanalfilters F ist ein Quadratursignalpaar, das aus einem Inphasesignal i und einem Quadraturphasesignal q besteht. In Fig. 3 sind diese beiden Signale i, q schematisch in einem kartesischen Koordinatensystem x, y dargestellt. Das Quadratursignalpaar i, q läßt sich als eine Rechtwinkel-Komponentendarstellung eines resultierenden Signals R deuten, das gegenüber einer Bezugsphase den Phasenwinkel ( = Phase) p aufweist und dessen Länge durch den Betrag b gegeben ist. Fällt die Frequenz des Überlagerungsignalpaars s, c genau mit der mittleren Frequenz des FM-modulierten Trägers zusammen, dann wird durch den Phasenwinkel p die momentane Phasenabweichung des empfangenen FM-Signals von der mittleren Tonträgerphase dargestellt. Die Differenzierung dieses Phasenwinkels p führt bekanntlich zur gewünschten FM-Demodulation. Von diesem Verfahren macht der vorliegende Demodulator D in der Tonkanalverarbeitungsschaltung T Gebrauch.

Der Demodulator D enthält einen Phasenumwandler P, der aus dem Inphasesignal i und dem Quadraturphasesignal q den Phasenwinkel p bildet und zusätzlich den Betrag b des resultierenden Signals R abgibt - dies entspricht bis auf die Differenzierung einer FM- und einer AM-Demodulation. Derartige Phasenumwandler P verwenden in der Regel Iterationsverfahren zur Bestimmung der Phase und des Betrags, wobei das bekannteste Verfahren das "Cordic-Verfahren" ist. Andere Phasenumwandler P benutzen gespeicherte Tabellenwerte oder wenden eine vereinfachte Reihenentwicklung an.

Wie oben angegeben, wird mit dem Phasenwinkel p bei der FM-Demodulation ein Differenzierer Di gespeist, dessen Ausgang mit dem Eingang FM eines elektronischen Umschalters sw verbunden ist. Während des Suchvorgangs ist jedoch der elektronische Umschalter sw so geschaltet, daß sein Eingang AM direkt mit dem Betrag b gespeist ist. Am Ausgang des elektronischen Umschalters ist die Tonstufe t mit der adaptiven Deemphasis und weiteren Filtereinrichtungen angeschlossen, die über Tonstufenkoeffizienten Kc von der zentralen Steuereinrichtung st gesteuert werden. Das digitale Ausgangssignal der Tonstufe t wird dann über einen Digital-Analogumsetzer da zurückgewandelt und einer Lautsprechergruppe l zugeführt. Während des Suchvorgangs ist die Tonstufe t selbstverständlich stummgeschaltet.

Die eigentliche Auswertung des Amplitudenpegels kann nur teilweise in der Tonstufe t erfolgen, da hierzu die entsprechenden Auswerteeinheiten fehlen. Über ein Pegelfilter PF, das mit den Amplitudenwerten der Tonstufe gespeist wird, ist es aber möglich, einen mittleren Amplitudenpegel des demodulierten Audiosignals zu ermitteln, und zwar mit einer niederen Filterzeitkonstante von ca. 15 Hz (oder 1 Hz bis 300 Hz). Der Ausgangswert dieses Pegelfilters, das auch als quadratischer Mittelwertbildner ( = RMS) bezeichnet wird, wird dann über einen Datenbus bu der zentralen Steuereinrichtung st zugeführt, die bei der normalen Tonwiedergabe entsprechend dem jeweils ermittelten Pegel die Tonstufenkoeffizienten Kc für die Deemphasis in der Tonstufe t optimiert.

Zur Bestimmung des relativen Amplitudenmaximums während der Suchlaufphase dient ein Extremwertdetektor ex, der aus benachbarten Meßintervallen das relative Amplitudenmaximum bestimmt. Sind mehrere relative Maxima vorhanden, dann bestimmt eine Auswerteeinrichtung w mittels der zugehörigen Frequenz des Überlagerungssignalpaares s, c und mittels der absoluten Amplitude, welches der Hauptträger h und welches die Unterträger u sind und welche Betriebskoeffizienten Kt und welche Tonstufenkoeffizienten Kc bei Beendigung des Suchlaufs einzustellen sind.

Da der Datentakt des Pegelfilters PF wegen dessen niederen Zeitkonstante sehr niedrig liegt, kann die Extremwertbestimmung und die Auswertung über ein einfaches Ablaufprogramm als Software in der zentralen Steuereinrichtung st erfolgen. Zur Extremwertbestimmung müssen lediglich die Differenzen benachbarter mittlerer Amplituden gebildet und der Umkehrpunkt des Vorzeichens festgestellt werden. Der Umkehrpunkt definiert das relative Amplitudenmaximum. Die Auswerteeinrichtung w bestimmt zusätzlich aus den absoluten "RMS"-Werten (RMS = Root Mean Square) des Pegelfilters PF, ob es sich um Haupt- oder Unterträger handelt und ordnet je nach der Entscheidung die notwendigen Betriebskoeffizienten Kt für die Bandbreite des Tonkanalfilters F sowie die notwendigen Tonkanalkoeffizienten Kc für die Deemphasis der Tonstufe t zu.

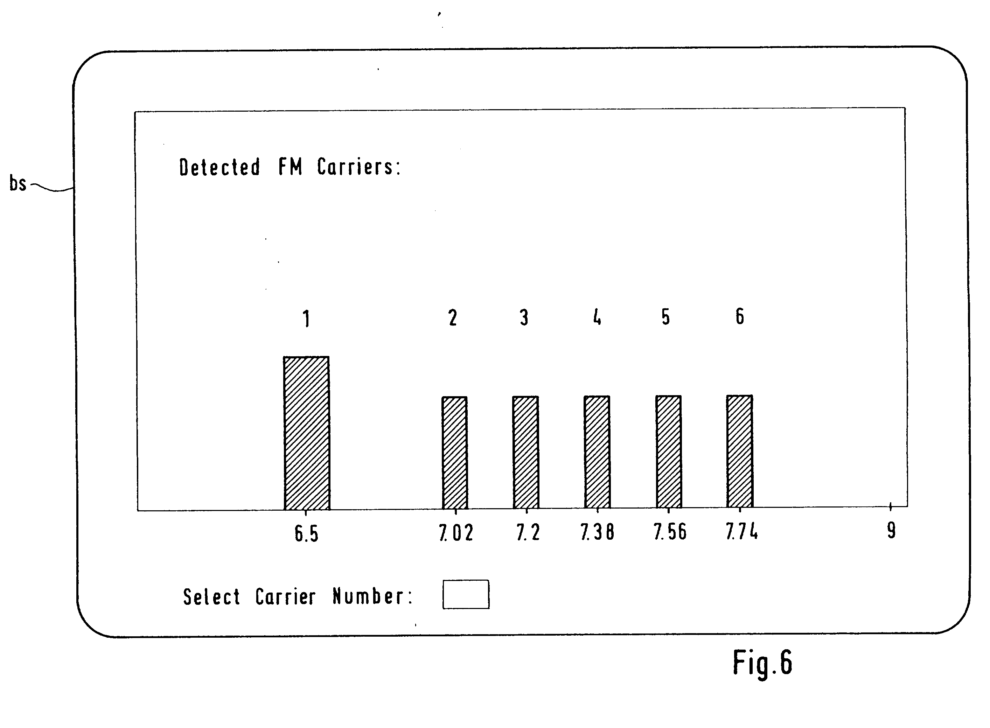

In der Festwerttabelle der Auswerteeinrichtung w sind auch Daten enthalten, die einem On-Screen-Display-Prozessor DP zugeführt sind, der üblicherweise der Teletextdarstellung dient oder eine hochauflösende Graphik auf einem Bildschirm bs über eine Pixelsteuerung ermöglicht. Auf diese Weise stellt der Bildschirm bs des Fernsehempfängers eine äußerst effektive Anzeigeeinrichtung S dar, die zusätzlich mit einer Menue-Steuerung kombiniert werden kann. Über einen Fernbedienungsgeber ge werden die einzelnen Befehle dem Fernsehempfänger zugeführt, der sie über einen Instruktionsbus bi intern an die zentrale Steuereinrichtung st weitergibt. In Fig. 6 ist hierzu als Beispiel eine mögliche Darstellung der vorhandenen Tonträger gezeigt, und zwar als Balkendiagramm mit den zugehörigen Tonträgermittenfrequenzen auf der horizontalen Achse und mit einer Durchnumerierung der einzelnen Tonträger oberhalb des zugehörigen Balkens. Der besseren Unterscheidung wegen ist der Hauptträger mit der Kennziffer 1 deutlich von den Unterträgern 2 bis 6 unterschieden. Im unteren Darstellungsbereich steht die Aufforderung, daß eine Träger-Kennziffer ausgewählt werden soll. Läßt der ausgewählte Träger einen Stereo-Betrieb zu, dann könnte die nächste Menue-Anfrage lauten: "Mono 1 - Stereo 2" usw.

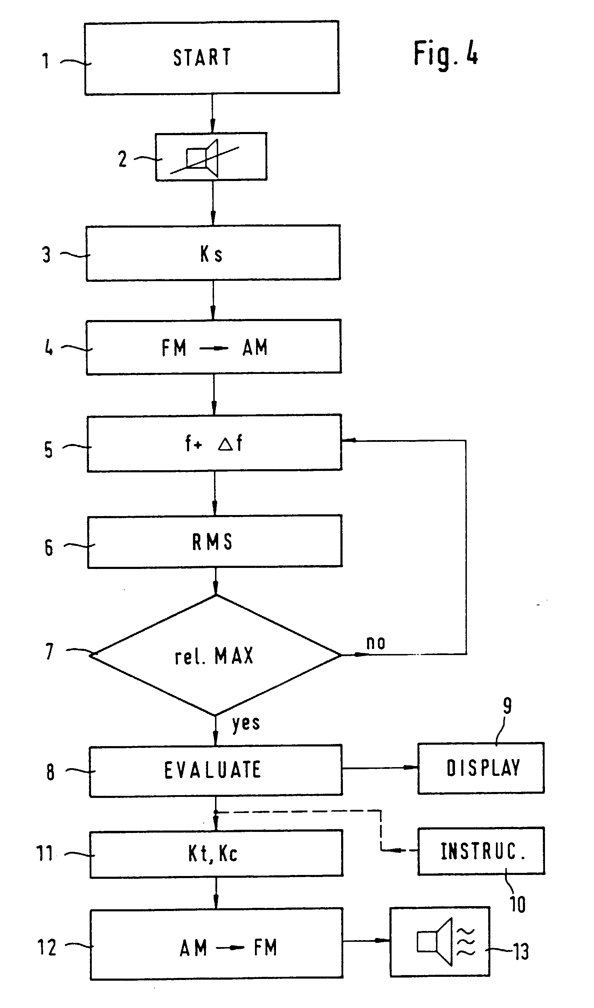

Fig. 4 zeigt schematisch in einem ersten Flußdiagramm ein erstes Beispiel für die Verfahrensschritte zur Durchführung des Suchlaufs nach der Erfindung. Das Flußdiagramm beginnt mit der Suchlauf-Startauslösung 1, die beispielsweise über die Fernbedienungseinrichtung aktiviert werden kann. Im nächsten Schritt 2 wird der Audiokanal stummgeschaltet, und im Schritt 3 werden die Suchlaufkoeffizienten Ks für das Kanalfilter F eingestellt, wodurch die Bandbreite auf den Suchlaufwert reduziert wird. Im nächsten Schritt 4 wird der Demodulator D auf AM-Demodulation umgeschaltet. In der Schaltungsausführung nach Fig. 2 muß hierzu lediglich der elektronische Umschalter sw in die Schaltposition AM umgesteuert werden.

Nach diesen Vorbereitungen kann der eigentliche Suchlaufvorgang beginnen. Im Schritt 5 wird die Frequenz des Überlagerungsignalpaars s, c um 10 kHz erhöht. Die zentrale Steuereinrichtung st ändert hierzu den Wert des ersten Datenwortes f1 um einen Betrag, der dem gewünschten Suchlaufschritt entspricht. Im Schritt 6 wird über eine Mittelwertbildung (RMS = Root Mean Square) die mittlere effektive Signalamplitude im Meßintervall bestimmt. In Fig. 2 erfolgt dies durch das Pegelfilter PF. Im nächsten Schritt 7 muß die Entscheidung getroffen werden, ob die mittlere effektive Signalamplitude ein relatives Maximum darstellt oder nicht. Handelt es sich um kein relatives Maximum, dann wird die Überlagerungsfrequenz um einen weiteren Schritt erhöht. Wird ein relatives Maximum festgestellt, dann wird dieser Amplitudenwert im folgenden Schritt 8 einer weiteren Auswertung (= EVALUATE) unterzogen, die in Verbindung mit der zugehörigen Frequenz und gegebenenfalls absoluten Amplitude feststellt, ob der erkannte Tonträger ein Haupt- oder Unterträger h, u ist. Dies wird dann auf einer Anzeigeeinrichtung (= DISPLAY) im Schritt 9 dargestellt. Die Anzeigeeinrichtung kann im einfachsten Fall eine Kontrolleuchte oder eine alphanumerische Anzeige sein. Ob es sich bei dem gefundenen Tonträger schon um den gewünschten Tonträger handelt, wird durch den Bedienungsschritt 10 festgestellt, mit dem die Audiowiedergabe dieses Tonträgers aktiviert wird. Wenn dieser Tonträger nicht gewünscht wird, was durch das "Hineinhören" festgestellt wird, dann wird über die Auslösung des Startschrittes 1 der Suchvorgang für den nächsten Tonträger fortgesetzt.

Bei Beendigung des Suchvorgangs, also vor der Audiowiedergabe, müssen die Betriebskoeffizienten Kt des Kanalfilters F und die Tonstufenkoeffizienten Kc der Tonstufe t normalisiert werden, dies erfolgt im Schritt 11. Im Schritt 12 erfolgt schließlich die Umschaltung des Demodulators D auf FM-Demodulation; und Schritt 13 hebt schließlich die Stummschaltung wieder auf.

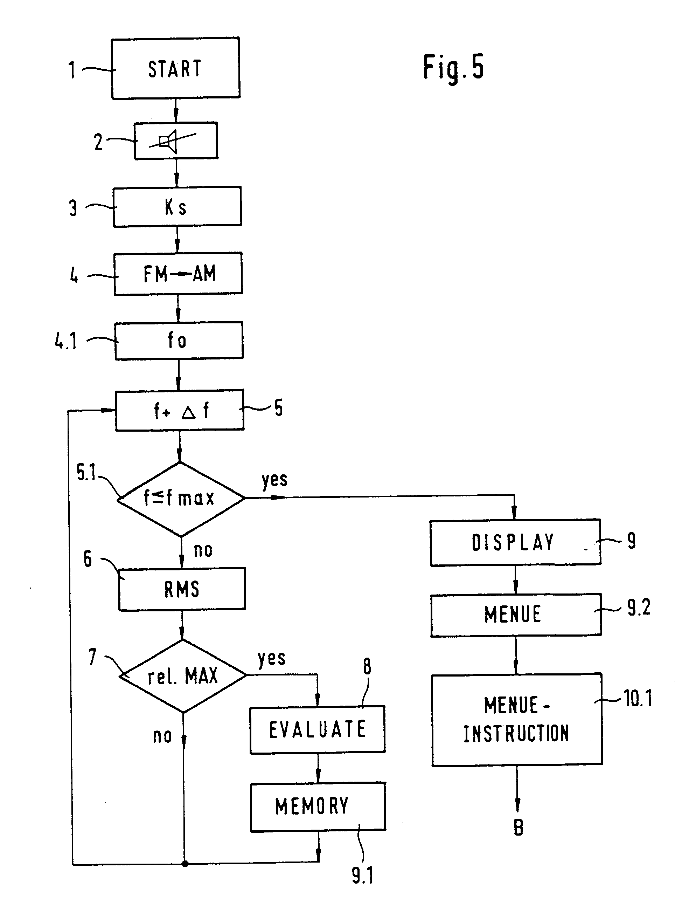

Fig. 5 zeigt schematisch als Funktionsdiagramm ein zweites Suchlaufverfahren nach der Erfindung, das einen größeren Bedienungskomfort ermöglicht. Der besseren Übersicht wegen sind gleiche Funktionseinheiten in den Figuren 4 und 5 mit gleichen Bezugszeichen versehen und brauchen daher nicht nochmals näher erläutert zu werden.

Nach dem Funktionsdiagramm von Fig. 5 wird der Suchlauf von einer Startfrequenz fo, die etwa bei 5 MHz liegt, ohne Unterbrechnung über die gesamten Trägerbereiche bis ca. 9 MHz geführt. Mittels einer schematischen Darstellung werden diese Träger zusammen mit einer Menue-Steuerung auf dem Bildschirm des Fernsehempfängers dargestellt und die gewünschten Tonträger ausgewählt.

Das Funktionsdiagramm von Fig. 5 beginnt mit den bekannten Schritten 1 bis 4, denen dann der neue Schritt 4.1 folgt, mit dem die Startfrequenz fo eingestellt wird. Von dieser Startfrequenz fo ausgehend, wird im Schritt 5 die Suchlauffrequenz f in jedem Meßintervall um eine Frequenzstufe erhöht. Diese Frequenzerhöhung wird solange fortgesetzt, bis die Überprüfung im Schritt 5.1 ergibt, daß die Maximalfrequenz fmax bei ca. 9 MHz erreicht ist. Ist die Maximalfrequenz jedoch noch nicht erreicht, dann wird über die bekannten Schritte 6, 7 und 8 ein eventuell vorhandenes relatives Amplitudenmaximum festgestellt und ausgewertet. In einer Speichereinrichtung (= MEMORY) wird dann im Schritt 9.1 dieses relative Maximum zusammen mit der zugehörigen Frequenz und eventuell mit dem absoluten Amplitudenwert abgespeichert.

Wenn im Schritt 5.1 festgestellt wird, daß die Maximalfrequenz fmax erreicht ist, dann wird der Inhalt der Speichereinrichtung im Schritt 9 auf dem Bildschirm (= DISPLAY) dargestellt, wobei die Darstellung über einen On-Screen-Display-Prozessor DP (vgl. Fig. 2) gesteuert wird. Die Darstellung auf dem Bildschirm wird dabei im Schritt 9.2 durch eine Menue-Anfrage ergänzt, die eine gezielte Auswahl aus den schematisch dargestellten Tonträgern ermöglicht. Ein Beispiel für eine derartige kombinierte Darstellung zeigt Fig. 6.

Die Antwort auf die Menue-Anfrage erfolgt mit dem Schritt 10.1, beispielsweise durch eine Kennziffer-Eingabe für den auszuwählenden Tonträger. Die übermittelte Kennziffer löst in der zentralen Steuereinrichtung st über einen entsprechenden Befehl (= MENUE-INSTRUCTION), die aus Fig. 4 bekannten Endschritte 11 bis 13 aus, die in Fig. 5 nicht dargestellt sind, jedoch in Fig. 4 nach dem Punkt B folgen.

## Patentansprüche

1. Verfahren zur Frequenzabstimmung der frequenzmodulierten Tonträger von Mehrton-Übertragungsstandards bei einem für TV-Satellitenempfang geeigneten Fernsehempfänger unter Verwendung einer digitalen Tonkanalverarbeitungseinrichtung (T) mit einem Quadraturmischer (m), einem Kanalfilter (F), einem Demodulator (D), einer Tonstufe (t) und einer zentralen Steuereinrichtung (st), die mittels eines in der Frequenz programmierbaren digitalen Generators (gl) den Quadraturmischer durchstimmt,
gekennzeichnet durch folgende Merkmale:
- die Frequenzabstimmung erfolgt als automatische Suchlaufsteuerung, wobei ein Überlagerungssignalpaar (s, c) stufenweise in seiner Frequenz verändert wird und jeder Suchlauf-Frequenzschritt ein Meßintervall darstellt,
- der Durchlaßbereich des Kanalfilters (F) wird durch die zentrale Steuereinrichtung (st) auf eine Bandbreite umgeschaltet, die zwischen der zweifachen und fünffachen Bandbreite des Suchlauf-Frequenzschrittes liegt,
- der am Ausgang des Kanalfilters (F) angeschlossene Demodulator (D) wird durch die zentrale Steuereinrichtung (st) auf eine Amplitudendemodulation umgeschaltet,
- mittels einer Extremwertbestimmung wird aus benachbarten Meßintervallen der relative Maximalwert der Amplitude bestimmt und dieser Wert einer Auswerteeinrichtung (w) und einer Anzeigeeinrichtung (S) zugeführt, wobei die Zuordnung zum zugehörigen Suchlauf-Frequenzschritt mittels der zentralen Steuereinrichtung (st) für die Auswerte- und Anzeigeeinrichtung erhalten bleibt.

2. Verfahren nach Anspruch 1, dadurch gekennzeichnet, daß der Demodulator (D) einen Phasenumwandler (P) und einen Differenzierer (Di) enthält, die aus dem Inphase- und Quadraturphasesignal (i, q) des Quadraturmischers (m) die jeweilige Phase (p) und/oder den jeweiligen Betrag (b) des resultierenden Signals (R) bestimmen und diese Werte als Ausgangssignale abgeben.

3. Verfahren nach Anspruch 1, dadurch gekennzeichnet, daß die Anzeigeeinrichtung (S) eine graphische oder alphanumerische Darstellung auf dem Bildschirm (bs) des Fernsehempfängers bewirkt.

4. Verfahren nach Anspruch 3, dadurch gekennzeichnet, daß die Darstellung auf dem Bildschirm (bs) mit einer Menue-Darstellung und einer Menue-Steuerung kombiniert ist, die dem Betrachter eine Auswahl des oder der angebotenen Fernseh-Tonträger (h, u) ermöglicht.

5. Verfahren nach Anspruch 4, dadurch gekennzeichnet, daß auf dem Bildschirm (bs) die erfaßten Tonträger (h, u) schematisch als Balkendiagramme über der Frequenz dargestellt sind und daß die gewünschten Tonträger (h, u) über eine Kennziffer oder ein Erkennungssymbol mittels der Menue-Steuerung vom Bedienenden ausgewählt werden.

6. Verfahren nach Anspruch 4, dadurch gekennzeichnet, daß die Darstellung auf dem Bildschirm (bs) durch eine hochauflösende Pixel-Steuerung erfolgt.

7. Verfahren nach Anspruch 6, dadurch gekennzeichnet, daß die hochauflösende Pixel-Steuerung mittels eines im Fernsehempfänger vorhandenen pixelorientierten On-Screen-Display-Prozessors (DP) erfolgt.

8. Verfahren nach Anspruch 1, dadurch gekennzeichnet, daß mit dem Amplitudenwert ein Pegelfilter (PF) gespeist wird, das Teil einer vorhandenen adaptiven Filtereinrichtung in der Tonstufe (t) ist und daß das Ausgangssignal dieses Pegelfilters über einen Datenbus (bu) der zentralen Steuereinrichtung (st) zugeführt wird, die auch als Extremwertdetektor (ex) und Auswerteeinrichtung (w) dient.

9. Verfahren nach Anspruch 8, dadurch gekennzeichnet, daß das Pegelfilter (PF) ein quadratischer Mittelwertbildner mit einer Zeitkonstante zwischen 1 Hz und 300 Hz ist.

10. Verfahren nach Anspruch 1, dadurch gekennzeichnet, daß aus dem Verhältnis der absoluten Amplitudenwerte, die über die Extremwertbestimmung ermittelt worden sind, die Auswerteeinrichtung (w) zwischen Haupt- und Unterträgern (h, u) unterscheidet und nach Beendigung des Suchlaufs mittels der zentralen Steuereinrichtung (st) automatisch die erforderliche FM-Bandbreite für das Kanalfilter (F) und die erforderliche Deemphasis in der Tonstufe (t) über Betriebs- bzw. Tonstufenkoeffizienten (Kt, Kc) einstellt.

## Claims

1. Method for frequency-tuning the frequency-modulated sound carriers of multichannel sound transmission standards in a television receiver suitable for TV satellite reception using a digital sound-channel-processing section (T) comprising a quadrature mixer (m), a channel filter (F), a demodulator (D), a sound stage (t), and a central control unit (st) which continuously tunes the quadrature mixer by means of a frequency-programmable digital generator (g1).
characterized by the following features:
- The frequency tuning is implemented as an automatic search-tuning control, with the frequency of a heterodyne-signal pair (s, c) being changed in steps and each search-tuning-frequency step representing one measurement interval;
- the passband of the channel filter (F) is switched by the central control unit (st) to a bandwidth lying between twice and five times the bandwidth of the search-tuning-frequency step;
- the demodulator (D), which is connected to the output of the channel filter (F), is switched by the central control unit (st) to amplitude demodulation;
- by means of an extreme-value detection, the relative maximum value of the amplitude is determined from adjacent measurement intervals, and this value is fed to an evaluating device (w) and a display device (S), with the assignment to the associated search-tuning-frequency step being preserved for the evaluating device and the display device by means of the central control unit (st).

2. A method as claimed in claim 1, characterized in that the demodulator (D) includes a phase converter (P) and a differentiator (D*i*) which determine the respective phase (p) and/or the respective magnitude (b) of the resultant signal (R) from the in-phase and quadrature-phase signals (i, q) provided by the quadrature mixer (m), and deliver these values as output signals.

3. A method as claimed in claim 1, characterized in that the display device (S) provides a graphic or alphanumeric display on the screen (bs) of the television receiver.

4. A method as claimed in claim 3, characterized in that the display on the screen (bs) is combined with a menu display and a menu control which allows the viewer to select the television sound carrier or carriers offered (h, u).

5. A method as claimed in claim 4, characterized in that on the screen (bs), the detected sound carriers (h, u) are displayed schematically in bar-chart form as a function of frequency, and that the desired sound carriers (h, u) are selected by the operator by means of the menu control via an identifying number or symbol.

6. A method as claimed in claim 4, characterized in that the display on the screen (bs) is provided via a high-resolution pixel control.

7. A method as claimed in claim 6, characterized in that the high-resolution pixel control is accomplished by means of a pixel-oriented on-screen-display processor (DP) contained in the television receiver.

8. A method as claimed in claim 1, characterized in that the amplitude value is fed to a level filter (PF) which forms part of an existing adaptive filter device in the sound stage (t), and that the output of this level filter is transferred over a data bus (bu) to the central control unit (st), which also serves as an extreme-value detector (ex) and as the evaluating device (w).

9. A method as claimed in claim 8, characterized in that the level filter (PF) is a root-mean-square detector with a time constant between 1 Hz and 300 Hz.

10. A method as claimed in claim 1, characterized in that the evaluating device (w) distinguishes between main and subcarriers (h, u) based on the ratio of the absolute amplitude values determined by the extreme-value detection and, after termination of the search-tuning process, automatically adjusts the necessary FM bandwidth for the channel filter (F) and the necessary deemphasis in the sound stage (t) by means of the central control unit (st) via the operational and sound-stage coefficients (Kt, Kc), respectively.

## Revendications

1. Procédé d'accord de fréquence des porteuses audio modulées en fréquence de standards de communication multiphoniques dans un récepteur de télévision convenant à la réception TV par satellites en utilisant un dispositif de traitement numérique du canal audio (T) comportant un mélangeur en quadrature (m), un filtre de canal (F), un démodulateur (D), un étage audio (t) et un dispositif de commande central (st), qui fait varier l'accord du mélangeur en quadrature au moyen d'un générateur numérique (g1) programmable en fréquence, caractérisé par les caractéristiques suivantes :
- l'accord de fréquence se fait sous la forme d'une commande de balayage automatique, dans laquelle deux signaux de superposition (s, c) sont modifiés en fréquence par paliers et chaque incrément de fréquence de balayage représente un intervalle de mesure,
- la plage passante du filtre de canal (F) est commutée par le dispositif de commande central (st) sur une largeur de bande, qui se situe entre deux fois et cinq fois la largeur de bande de l'incrément de fréquence de balayage,
- le démodulateur (D) raccordé à la sortie du filtre de canal (F) est commuté par le dispositif de commande central (st) sur une démodulation d'amplitude,
- par détermination de valeurs extrêmes, on détermine, à partir d'intervalles de mesure voisins, la valeur maximale relative de l'amplitude et cette valeur est acheminée à un dispositif d'exploitation (w) et à un dispositif d'affichage (S), l'affectation à l'incrément de fréquence de balayage concerné restant maintenue, au moyen du dispositif de commande central (st), pour le dispositif d'exploitation et d'affichage.

2. Procédé selon la revendication 1, caractérisé en ce que le démodulateur (D) contient une convertisseur de phase (P) et un différenciateur (Di), qui déterminent, à partir du signal en phase et du signal en quadrature de phase (i, q) du mélangeur en quadrature (m), la phase respective (p) et/ou la somme respective (b) du signal obtenu (R) et délivrent ces valeurs comme signaux de sortie.

3. Procédé selon la revendication 1, caractérisé en ce que le dispositif d'affichage (S) effectue une représentation graphique ou alphanumérique sur l'écran (bs) du récepteur de télévision.

4. Procédé selon la revendication 3, caractérisé en ce que la représentation sur l'écran (bs) est combinée à une représentation de menu et à une commande de menu, ce qui permet à l'observateur de choisir le ou les porteuses audio de télévision offertes (h, u).

5. Procédé selon la revendication 4, caractérisé en ce que, sur l'écran (bs), les porteuses audio captées (h, u) sont représentées schématiquement sous la forme d'un diagramme de barres vis-à-vis de la fréquence et en ce que les porteuses audio souhaitées (h, u) sont choisies par l'opérateur via un chiffre ou un symbole d'identification à l'aide de la commande de menu.

6. Procédé selon la revendication 4, caractérisé en ce que la représentation sur l'écran (bs) se fait par une commande de pixels de haute résolution.

7. Procédé selon la revendication 6, caractérisé en ce que la commande de pixels de haute résolution se fait à l'aide d'un processeur d'affichage sur écran (DP) orienté par pixels, présent dans le récepteur de télévision.

8. Procédé selon la revendication 1, caractérisé en ce que la valeur d'amplitude est acheminée à un filtre de niveau (PF), qui fait partie d'un dispositif de filtrage adaptatif présent dans l'étage audio (t) et en ce que le signal de sortie de ce filtre de niveau est acheminé, via un bus de données (bu), au dispositif de commande central (st), qui sert également de détecteur de valeurs extrêmes (ex) et de dispositif d'exploitation (w).

9. Procédé selon la revendication 8, caractérisé en ce que le filtre de niveau (PF) est un dispositif de valeurs quadratiques moyennes avec une constante de temps entre 1 et 300 Hz.

10. Procédé selon la revendication 1, caractérisé en ce que, à partir du rapport des valeurs d'amplitude absolues, qui ont été déterminées par la détermination de valeurs extrêmes, le dispositif d'exploitation (w) distingue entre les porteuses principales et les sous-porteuses (h, u) et, à la fin du balayage, au moyen du dispositif de commande central (st), on règle automatiquement la largeur de bande FM requise pour le filtre de canal (F) et la désaccentuation requise dans l'étage audio (t) via des coefficients d'exploitation ou des coefficients de l'étage audio (Kt, Kc).
